# EUROPÄISCHE PATENTSCHRIFT

(11) **EP 0 920 126 B1**
(45) Veröffentlichungstag und Bekanntmachung des Hinweises auf die Patenterteilung: **11.02.2004**
(21) Anmeldenummer: 98120169.2
(22) Anmeldetag: 28.10.1998
(51) Int. Cl.: H03G 3/30, H04B 7/26

(54) **Verfahren und Vorrichtung zum adaptiven Regeln des Verstärkungsfaktors eines Verstärkers**
Method and apparatus for adaptively controlling the gain of an amplifier
Procédé et dispositif de commande adaptive du gain d'un amplificateur

(30) Priorität: 26.11.1997 DE 19752283
(43) Veröffentlichungstag der Anmeldung: 02.06.1999
(73) Patentinhaber: Deutsche Telekom AG, 53113 Bonn (DE)
(72) Erfinder: Lorenz, Rudolf Werner, Dr.-Ing., 64401 Gross-Bieberau (DE); Dannowski, Klaus, Dr.-Ing., 01217 Dresden (DE); Freiburger, Georg, Dr.-Ing., 01067 Dresden (DE); Rau, Armin, Dr.-Ing., 01307 Dresden (DE)

(56) Entgegenhaltungen:
- EP-A- 0 772 310
- US-A- 4 776 032

## Beschreibung

Die Erfindung betrifft eine Vorrichtung zur geregelten Verstärkung von digitalen Signalen, insbesondere für ein digitales Rundfunksystem, nach Anspruch 1 sowie ein Verfahren zum adaptiven Regeln des Verstärkungsfaktors einer Verstärkungsvorrichtung gemäß Anspruch 14.

In jüngster Zeit werden digitale terrestrische Rundfunksyteme, wie z. B.das DAB (Digital Audio Broadcasting)-T- oder das DVB (Digital Video Broadcasting)-T-System, in Gleichwellennetzen betrieben, bei denen von mehreren Standorten aus synchron gesendet wird. Zur Füllung von Versorgungslücken werden Repeaterverstärker eingesetzt, deren Sende- und Empfangsantennen aufgrund einer Strahlungskopplung rückgekoppelt sind. Wenn die Verstärkung eines Repeaterverstärkers die Entkopplungsdämpfung zwischen dessen Sende- und Empfangsantenne erreicht, gerät dieser in Schwingung. Um Schwingungen und damit einen instabilen Betrieb zu vermeiden, muß die Verstärkung um einen Sicherheitsabstand kleiner sein als die Entkopplungsdämpfung. Unter dem Sicherheitsabstand versteht man ganz allgemein die in dB gemessene Differenz zwischen der Entkopplungsdämpfung zwischen dem Ein- und Ausgang eines Verstärkers und dessen Verstärkungsfaktor. Da die Strahlungskopplung zwischen der Sende- und Empfangsantenne des Repeaterverstärkers durch Umgebungseinflüsse, wie z. B. durch vor einer Antenne fliegende Objekte (Flugzeuge, Vögel, Schnee u.s.w.) oder durch zeitweise auf der Antenne befindlichen Objekte, zeitvariant sein kann, kann die Entkopplungsdämpfung zeitweise derart verkleinert sein, daß der Repeaterverstärker in Schwingung gerät. Um einen stabilen Betrieb zu gewährleisten, sind bisher bekannte, geregelte Verstärker oder Repeater-Verstärker derart ausgebildet, daß deren Verstärkung statisch um einen erheblichen Sicherheitsabstand, beispielsweise um 15 dB, unter einer gemessenen mittleren Entkopplungsdämpfung eingestellt wird. Die mittlere Entkopplungsdämpfung ergibt sich im wesentlichen aus systembedingten Eigenschaften, wie z.B. der Orientierung der Sende- und Empfangsantenne, dem Abstand der Antennen zueinander und der höhenversetzten Montage der Sende- und Empfangsantennen. Obwohl bei den bekannten Repeatern der Sicherheitsabstand recht groß gewählt ist, kann es trotzdem zur Selbsterregung des Repeaterverstärkers kommen, wenn sich die Entkopplungsdämpfung zeitweise oder dauerhaft drastisch verringert. Eine Herabsetzung des Sicherheitsabstandes tritt auch ein, wenn der Signalpegel am Repeater-Ausgang abnimmt, weil dann bei der üblichen Regelung der Ausgangsleistung die Verstärkung ansteigt, um dem Absinken der Ausgangsleistung entgegenzuwirken. Bei den herkömmlichen Repeater-Verstärkern, deren Verstärkung unabhängig von der aktuellen Entkopplungsdämpfung eingestellt wird, ist es ferner sehr schwierig festzustellen, ob der Sicherheitsabstand bezüglich des Schwingeinsatzpunktes mit viel zu großer Reserve eingestellt worden ist und dadurch Versorgungsreichweite und - qualität verschenkt wird, wodurch der Repeater unwirtschaftlich betrieben wird.

Der Erfindung liegt daher die Aufgabe zugrunde, den eingangs erwähnten Verstärker derart weiterzuentwickeln, daß dieser wirtschaftlicher als bisher betrieben werden kann.

Dieses technische Problem löst die Erfindung jeweils mit den Merkmalen des Anspruchs 1 und den Verfahrensschritten des Anspruchs 14.

Die Erfindung berücksichtigt die Tatsache, daß digitale Kommunikationssysteme leistungsfähige Fehlererkennungs- und Fehlerkorrekturverfahren zur Vermeidung von Empfangsstörungen anwenden. Deshalb ist es durchaus tolerierbar, daß ein Verstärker über eine kurze Zeitdauer von beispielsweise einigen Mikrosekunden mit schlechter Übertragungsqualität oder sogar mit einer Unterbrechung der Übertragung instabil betrieben werden kann, ohne daß ein Zuhörer oder Zuschauer dies bemerkt.

Der Kerngedanke der Erfindung ist darin zu sehen, daß durch wiederholtes kurzeitiges Hochtasten der Verstärkung geprüft wird, ob die Verstärkung für einen stabilen Betrieb des Verstärkers vergrößert werden kann oder verkleinert werden muß. Auf diese Weise wird erreicht, daß der Verstärker die meiste Zeit mit dem größtmöglichen Verstärkungsfaktor betrieben werden kann, wodurch sowohl die Versorgungsreichweite als auch die Versorgungsqualität gegenüber bekannten statischen Verstärkern verbessert werden kann.

Dies erreicht die Erfindung durch eine Vorrichtung zur geregelten Verstärkung von digitalen Signalen, insbesondere für ein digitales Rundfunksystem, mit einem Signaleingang und einem Signalausgang, wobei die Vorrichtung eine voreingestellte Verstärkung (V₀) liefert. Ferner ist eine Einrichtung zum Erhöhen der voreingestellten Verstärkung (V₀) um einen ersten vorbestimmten Betrag in vorbestimmten zeitlichen Abständen für jeweils eine vorbestimmte Zeitdauer sowie eine Überwachungs- und Auswerteeinrichtung zur Überwachung und Auswertung des Betriebszustandes der Vorrichtung wenigstens in den vorbestimmten zeitlichen Abständen vorgesehen. In Abhängigkeit des Ausgangssignals der Überwachungs- und Auswerteeinrichtung erfolgt eine Vergrößerung oder eine Verkleinerung der voreingestellten Verstärkung um einen zweiten vorbestimmten Betrag. Beispielsweise beträgt der erste vorbestimmte Betrag 9 dB und der zweite vorbestimmte Betrag 0,5 dB. Der erste vorbestimmte Betrag entspricht dabei der gewünschten maximalen Differenz, auch Sicherheitsabstand genannt, zwischen einer mittleren Entkopplungsdämpfung zwischen dem Eingang und dem Ausgang des Verstärkers sowie dessen Verstärkung.

Gemäß einer vorteilhaften Ausführungsform weist die Vorrichtung einen ersten regelbaren Verstärker zur Lieferung der voreingestellten Verstärkung auf, wobei die Einrichtung zum wiederholten vorübergehenden Erhöhen der Verstärkung einen zweiten regelbaren Verstärker, einen Taktgeber und einen mit dem zweiten regelbaren Verstärker verbundenen Tastimpulsformer aufweist. Der Taktgeber und der Tastimpulsformer legen dabei das periodisch wiederkehrende Zeitfenster fest, innerhalb dessen die voreingestellte Verstärkung angehoben und der Betriebszustand des Verstärkers geprüft wird. Das Ausgangssignal des Tastimpulsformers ist daher eine Impulsfolge mit einer durch den Taktgeber vorgegebenen Wiederholungsrate, wobei die Impulse eine einstellbare Impulsbreite von beispielsweise 40 µs besitzen. Die Amplitude der von dem Tastimpulsformer gebildeten Impulse ist derart gewählt, daß sie für die Erhöhung der voreingestellten Verstärkung um den ersten vorbestimmten Betrag sorgt. Vorteilhafterweise wählt der Tastimpulsformer in Verbindung mit dem Taktgeber die Zeitpunkte und die Dauer der Verstärkungsanhebung so, daß einerseits Störungen, die während der Verstärkungsanhebung erzeugt werden, wegen des Fehlerschutzes im Empfänger nicht wahrnehmbar sind und andererseits im Verstärker die Information gewonnen und verarbeitet werden kann, daß der vorbestimmte Sicherheitsabstand außerhalb der Dauer der Verstärkungsanhebung eingehalten wird.

Bereits an dieser Stelle sei erwähnt, daß zur Optimierung der adaptiven Regelung der Verstärkung das am Signalausgang anliegende Signal dazu verwendet werden kann, die Taktfrequenz des Taktgebers und/oder die Impulsdauer der von dem Tastimpulsformer erzeugten Impulse zu verändern. Beispielsweise wird der Taktgeber durch ein Ausgangssignal aktiviert, wenn dessen Pegel einen voreingestellten, systemoptimierten Pegel überschreitet.

Zur Vergrößerung oder Verkleinerung der voreingestellten Verstärkung ist eine Verstärkungs-Steuerungseinrichtung vorgesehen, die eingangsseitig mit dem Taktgeber und der Überwachungs- und Auswerteeinrichtung sowie ausgangsseitig mit dem ersten Verstärker verbunden ist. Die Verstärkungs-Steuerungseinrichtung erhöht oder verkleinert die Verstärkung des ersten Verstärkers beispielsweise stufenweise um 0,5 dB. Allerdings ist der Verstärkungshub einstellbar.

Die erfindungsgemäße Vorrichtung kann vorteilhaft in einem geregelten Repeater für digitale Rundfunksysteme, wie z.B. in den DAB-T- und DVB-T-Systemen, eingesetzt werden. Ein solcher Repeater weist gewöhnlich eine Endstufe sowie ein Bandpaßfilter am Signalausgang auf. Das Bandpaßfilter hat die Aufgabe, Nebenaussendungen, das sind Signalfrequenzen außerhalb des vorbestimmten Frequenzbereichs, zu unterdrücken. Bei dem erfindungsgemäßen Verstärker hat das Bandpaßfilter ferner die Aufgabe zu verhindern, daß der Verstärker außerhalb des Übertragungsbandes schwingt, während es zugelassen wird, daß er kurzzeitig während der Dauer der Verstärkungsanhebung innerhalb des dem Funkdienst zugewiesenen Übertragungsbandes schwingt. Darüber hinaus ist der Repeater mit einem an sich bekannten Pegelindikator ausgerüstet, der eingangsseitig mit dem Signalausgang und ausgangsseitig mit der Verstärkungs-Steuerungseinrichtung verbunden ist, um die voreingestellte Verstärkung um einen vorbestimmten Betrag zu erhöhen, wenn die Signalleistung am Signalausgang den voreingestellten, systemoptimierten Leistungspegel unterschreitet. Systemoptimierter Leistungspegel heißt hier, daß der Pegel des Ausgangssignals zur Versorgung eines vorbestimmten Gebietes ausreicht.

Vorteilhafterweise ist die Verstärkungs-Steuerungseinrichtung mit dem Taktimpulsformer verbunden und erzeugt unter Ansprechen auf diesen unterschiedliche Verstärkersteuerungssignale. Auf diese Weise ist es möglich, daß die Verstärkungs-Steuerungseinrichtung die Verstärkung des ersten Verstärkers um einen größeren Schritt verkleinert, wenn eine Verschlechterung des Betriebszustandes des Verstärkers außerhalb der wiederholten, vorübergehenden Verstärkungsanhebung festgestellt wird.

Bei dem zu überwachenden und auszuwertenden Betriebszustand handelt es sich vorteilhafterweise um einen - möglichen Schwingungszustand der Vorrichtung. Das heißt, die Überwachungs- und Auswerteeinrichtung überwacht zunächst die Vorrichtung daraufhin, ob sie schwingt oder nicht. Wird eine Schwingung detektiert, wird die voreingestellte Verstärkung des ersten Verstärkers verringert. In diesem Fall handelt es sich bei der Überwachungs- und Auswerteeinrichtung um einen Schwingungsdetektor.

Gemäß einer weiteren Ausgestaltung der Überwachungsund Auswerteeinrichtung kann ein instabiler Betriebszustand der Vorrichtung dadurch festgestellt werden, daß die Änderung der Stromaufnahme der Vorrichtung, wenn dieser vom Betrieb der stabilen Verstärkung in den instabilen Betrieb der Schwingung übergeht, deren erhöhte Ausgangsleistung, das verstärkte Auftreten von Oberwellen aufgrund einer Amplitudenbegrenzung oder des Überschreitens der Linearitätsgrenze oder auch die Reduzierung oder das Verschwinden von Pegelschwankungen im verstärkten Signal ausgewertet wird.

Alternativ oder ergänzend kann die Überwachungs- und Auswerteeinrichtung derart ausgebildet sein, daß sie die Bitfehlerrate des empfangenen digitalen Signals überwacht und mit einem vorbestimmten Wert vergleicht. Eine weitere alternative Ausführungsform der Überwachungs- und Auswerteeinrichtung besteht darin, daß die Welligkeit der Übertragungsfunktion im Frequenzbereich analysiert wird. Das Überschreiten eines vorbestimmten Wertes erlaubt einen systembedingt festzulegenden Schwellenwert der Degradation der Signalübertragung zu erkennen. Eine Welligkeit der Übertragungsfunktion der Vorrichtung entsteht dadurch, daß durch eine Rückkopplung aus einer frequenzunabhängigen eine frequenzabhängige Übertragungsfunktion wird. Dabei gilt, daß die Welligkeit der Übertragungsfunktion um so größer wird, je kleiner der Sicherheitsabstand zum Schwingeinsatz der Vorrichtung ist. Eine andere Weiterbildung der Überwachungsund Auswerteeinrichtung ermöglicht die Überwachung und Auswertung von modulationsbedingten Pegelschwankungen im verstärkten Signal im Frequenzbereich. Als Beispiel sei an ein OFDM-Signal bei DAB-T-Sytemen gedacht. In diesem Fall wird eine Degradation der Signalübertragung erkannt, wenn die Pegelschwankungen unter einen vorbestimmten Wert fallen oder im wesentlichen völlig verschwinden. Mit diesen Kriterien und mit Hilfe entsprechend eingestellter Referenzwerte ist es möglich, den Übergang der Vorrichtung in einen instabilen Zustand bereits vor dem Einsetzen von Schwingungen zu erkennen.

Gemäß einer vorteilhaften Weiterbildung kann am Ausgang der Vorrichtung ein Amplitudenbegrenzer angeordnet sein, der durch den Taktgeber nur dann aktiviert wird, wenn die Verstärkung um den ersten Betrag angehoben wird.

Vorteilhafte Weiterbildungen sind Gegenstand der Unteransprüche.

Mit Hilfe der erfindungsgemäßen Vorrichtung und des erfindungsgemäßen Verfahrens ist es möglich, außerhalb der periodisch wiederkehrenden kurzen Zeitabschnitte, in denen die Verstärkung angehoben wird, einen vorbestimmten, minimalen Sicherheitsabstand einzuhalten, bei dem die Vorrichtung noch ausreichend stabil betrieben werden kann.

Die Erfindung wird nachstehend anhand eines Ausführungsbeispiels in Verbindung mit den beiliegenden Zeichnungen näher erläutert. Darin zeigen:
- Fig. 1: ein Blockschaltbild eines adaptiven Repeaters mit einer Schwingeinsatz-Überwachung,
- Fig. 2: ein Verstärkungs-Zeit-Diagramm der geregelten Verstärkung des regelbaren Verstärkers,
- Fig. 3: Zeit-Diagramm einer beispielhaften Impulsfolge, die vom in Fig. 1 gezeigten Tastimpulsformer zur Steuerung des stufenweisen regelbaren Verstärkers erzeugt wird, und
- Fig. 4: ein Verstärkungs-Zeit-Diagramm der Gesamtverstärkung des erfindungsgemäßen adaptiven Repeaters nach Fig. 1.

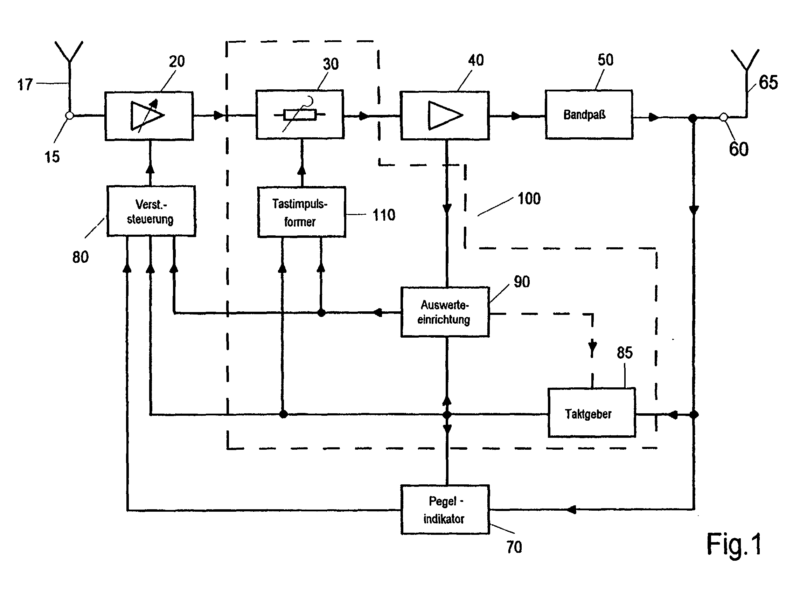

Fig. 1 zeigt die Prinzipschaltung eines adaptiven Repeaters, der beispielsweise in einem digitalen terrestrischen Rundfunksystem zur Auffrischung von digitalen Signalen verwendbar ist. Bereits an dieser Stelle sei erwähnt, daß die erfindungsgemäße Vorrichtung nicht nur in dem nachfolgend beschriebenen Repeater, sondern auch in anderen Verstärkern, bei denen der Ausgang mit dem Eingang gekoppelt ist, anwendbar sind. Der allgemein mit 10 bezeichnete adaptive Repeater umfaßt einen Signaleingang 15, an dem eine Empfangsantenne 17 angeschlossen ist. Die Empfangsantenne 17 ist mit einem regelbaren Verstärker 20 verbunden, der an sich bekannt ist. In an sich bekannter Weise enthält der Repeater 10 weiter eine als Leistungsverstärker aufgebaute Endstufe 40, ein Bandpaßfilter 50, einen Signalausgang 60 sowie eine daran angeschaltete Sendeantenne 65. Gewöhnlich ist ein Pegelindikator 70 eingangsseitig mit dem Signalausgang 60 verbunden, wobei dessen Ausgang über eine an sich bekannte Verstärkungs-Steuerungseinrichtung 80 mit dem regelbaren Verstärker 20 verbunden ist. Als erfindungswesentliche Komponente umfaßt der Repeater 10 eine adaptive Verstärkerstufe 100. Die adaptive Verstärkerstufe 100 umfaßt einen stufenweise regelbaren Verstärker 30, der eingangsseitig mit dem regelbaren Verstärker 20 und ausgangsseitig mit der Endstufe 40 verbunden ist. Darüber hinaus weist die adaptive Verstärkerstufe 100 einen Taktgeber 85 auf, der eingangsseitig mit dem Signalausgang 40 verbunden sein kann. Eine Überwachungs- und Auswerteeinrichtung 90 ist beispielsweise mit dem Ausgang der Endstufe 40 verbunden, wenn als Betriebszustand der Schwingeinsatz des Repeaters 10 überwacht wird. Darüber hinaus ist der Ausgang der Überwachungs- und Auswerteeinrichtung 90 mit einem Eingang eines Tastimpulsformers 110 verbunden. Der Tastimpulsformer 110 ist ausgangsseitig wiederum mit dem stufenweise regelbaren Verstärker 30 und der Verstärkungs-Steuerungseinrichtung 80 verbunden. Die Überwachungs- und Auswerteeinrichtung 90 ist ferner mit einem Eingang der Verstärkungs-Steuerungseinrichtung 80 und fakultativ mit einem Eingang des Taktgebers 85 verbunden. Der Taktgeber 85 kann sowohl mit einem Eingang des Tastimpulsformers 110 als auch mit einem Eingang der Verstärkungs-Steuerungseinrichtung 80 verbunden sein. Der Ausgang des Taktgebers 85 kann wiederum mit dem Eingang des Pegelindikators 70 und einem Eingang der Überwachungs- und Auswerteeinrichtung 90 verbunden sein.

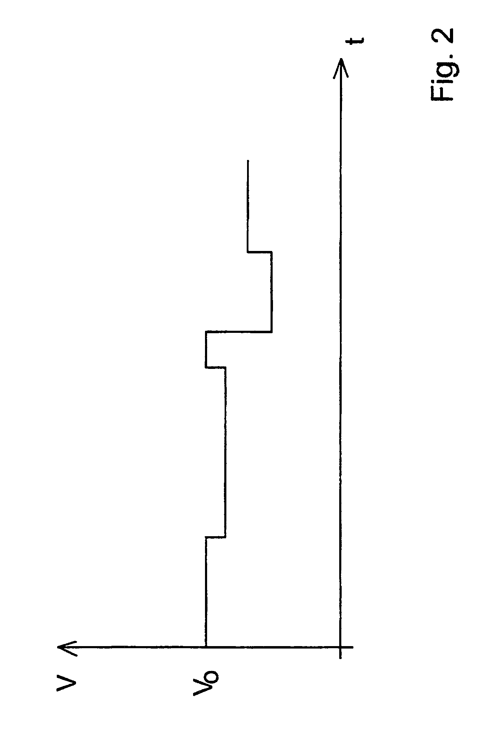

Die Betriebsweise des adaptiven Repeaters 10 wird nachfolgend in Verbindung mit den Fig. 2 bis 4 ausführlicher erläutert. Es sei angenommen, daß der adaptive Repeater 10 folgende voreingestellte Systemgrößen besitzt:
a) Die Verstärkung des regelbaren Verstärkers 20 betrage V₀; die Verstärkung ist derart gewählt, daß ein vorbestimmtes Gebiet vollständig versorgt werden kann;
b) der Sicherheitsabstand, d. h. die Differenz zwischen einer ermittelten mittleren Entkopplungsdämpfung zwischen der Sendeantenne 65 und der Empfangsantenne 17 des adaptiven Repeaters 10 und der optimierten Verstärkung Vₒ des Repeaters 10 betrage 9 dB,
c) die Periode des Taktsignals des Taktgebers 85 betrage 0,5 s,
d) die vom Tastimpulsformer 110 erzeugten Impulse besitzen eine Impulsbreite von 40 µs und bewirken eine Anhebung der Verstärkung des stufenweise regelbaren Verstärkers 30 um 9 dB bewirkt.

Die so gewählten Systemgrößen bewirken, daß der adaptive Repeater 10 in Schwingung gerät, wenn dessen Verstärkung um etwa 9 dB angehoben wird oder sich die Entkopplungsdämpfung um etwa 9 dB verschlechtert. Es sei ferner angenommen, daß die Überwachungs- und Auswerteeinrichtung 90 in dem vorliegenden Beispiel als Schwingungsdetektor ausgebildet ist, der erkennt, wenn der adaptive Repeater 10 in den Schwingungszustand übergeht.

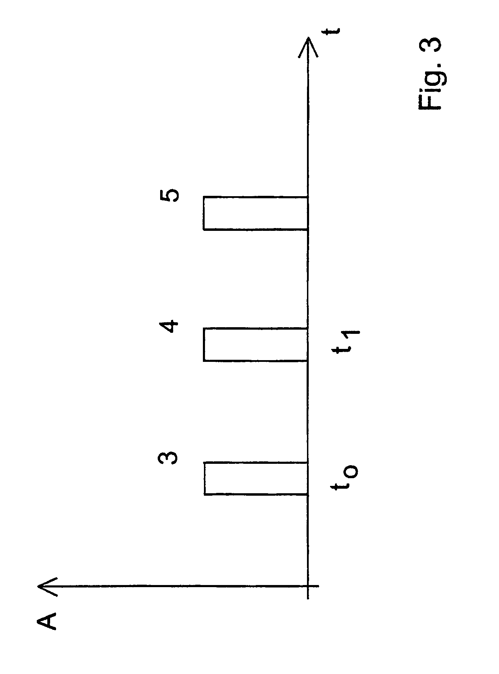

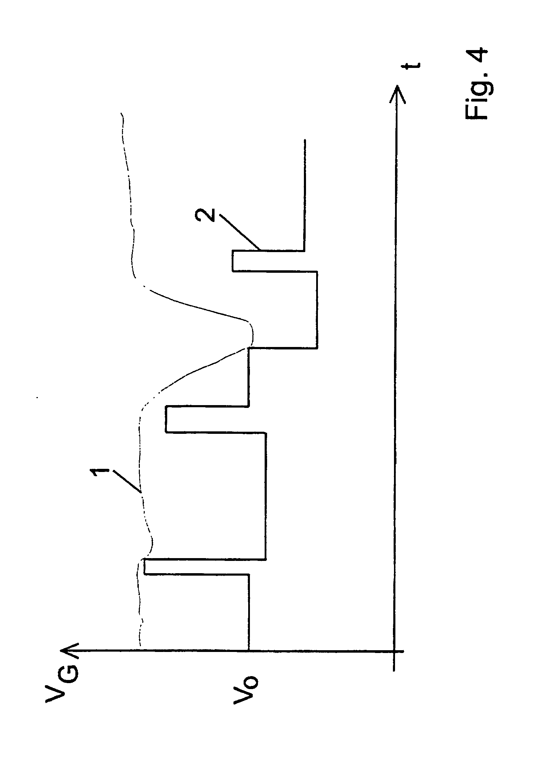

Es sei angenommen, daß sich der adaptive Repeater 10 anfänglich in einem stabilen Betriebszustand befindet, wobei die Verstärkung des regelbaren Verstärkers 20 zum Zeitpunkt T = 0 V₀ beträgt. Ferner ist der Repeater 10 derart ausgelegt, daß der Schwingungsdetektor 90 während der gesamten Betriebszeit aktiviert ist. Zum Zeitpunkt t₀ erzeugt, wie in Fig. 3 gezeigt, der Taktgeber 85 einen Taktimpuls, der den Tastimpulsformer 110 zur Erzeugung eines Impulses mit einer Dauer von 40 µs aktiviert. Dieser Impuls wird dem stufenweise regelbaren Verstärker 30 zugeführt, der unter Ansprechen darauf die Verstärkung des Repeaters 10 um 9 dB vergrößert. Die Gesamtverstärkung, die in Fig. 4 als Kurve 2 dargestellt ist, beträgt daher zum Zeitpunkt t₀ V₀ + 9 dB, was der mittleren Entkopplungsdämpfung entspricht. In der Praxis kann die mittlere Entkopplungsdämpfung etwas höher als die angehobene Gesamtverstärkung sein, um ein Schwingen des Repeaters 10 während einer Anhebung der Verstärkung des regelbaren Verstärkers 20 dann zu vermeiden, wenn die mittlere Verstärkung nicht herabgesetzt ist. Der zeitliche Verlauf der Entkopplungsdämpfung ist in Fig. 4 als Kurve 1 dargestellt. Wie in Fig. 4 gezeigt, ist die Entkopplungsdämpfung während der Zeitdauer des ersten Impulses 3, beispielsweise aufgrund eines vorbeifliegenden Vogels, abgefallen, so daß die Gesamtverstärkung des adaptiven Repeaters 10 größer als die Entkopplungsdämpfung ist. Der Schwingungsdetektor 90 stellt daher fest, daß der Repeater 10 schwingt. Da am Eingang der Verstärkungs-Steuerungseinrichtung 80 der erste Impuls 3 des Tastimpulsformers 110 anliegt, erkennt die adaptive Verstärkerstufe 100, daß der Repeater 10 während der periodischen Anhebung der Verstärkung V₀ des Repeaters 10 in Schwingung geraten ist. Die adaptive Verstärkerstufe 100 sei derart implementiert, daß die Verstärkung des stufenweise regelbaren Verstärkers 30 unmittelbar nach Feststellung des Schwingeinsatzes des Repeaters 10 auf Null reduziert wird und gleichzeitig die Verstärkung V₀ des Repeaters 10 über die Verstärkungs-Steuerungseinrichtung 80 um einen vorbestimmten kleinen Betrag, beispielsweise um 0,5 dB, verringert wird, wie dies in Fig. 4 dargestellt ist. Die Betriebsverstärkung des Repeaters 10 beträgt nunmehr V₀ - 0,5 dB. Zwar arbeitet der Repeater 10 nunmehr mit einer verringerten Verstärkung, doch der voreingestellte Sicherheitsabstand, der einen stabilen Betrieb gewährleistet, bleibt im wesentlichen erhalten. Wie in Fig. 4 dargestellt, steigt die Entkopplungsdämpfung nach dem kurzzeitigen Abfall wieder auf einen normalen Wert an, so daß der Schwingungsdetektor 90 zunächst keinen Schwingungseinsatz mehr detektiert. Nach Ablauf von 0,5 s erzeugt der Taktgeber einen weiteren Taktimpuls, der dem Tastimpulsformer 110 und dem Schwingungsdetektor 90 zugeführt wird, um zu signalisieren, daß die periodische Prüfung des Schwingungsverhaltens des Repeaters 10 wieder beginnt. Der Tastimpulsformer 110 erzeugt einen zweiten Impuls 4 mit einer Dauer von 40 µm, der wieder eine Anhebung der Verstärkung des stufenweise regelbaren Verstäkers 30 und damit der Gesamtverstärkung des Repeaters um 9 dB bewirkt. Die in Fig. 4 dargestellte Gesamtverstärkung beträgt zum Zeitpunkt t₁ somit V₀ + 9 dB - 0,5 dB. Da die Entkopplungsdämpfung zwischen der Empfangsantenne 17 und der Sendeantenne 65 größer ist als die Gesamtverstärkung des Repeaters 10, stellt der Schwingungsdetektor 90 kein Schwingen fest. Nach Ablauf von 40 µs wird die Verstärkung des stufenweise regelbaren Verstärkers 30 auf 0 dB reduziert und gleichzeitig die Verstärkung des regelbaren Verstärkers 20 um 0,5 dB angehoben, wie in Fig. 2 gezeigt.

Wie in Fig. 4 dargestellt, fällt nunmehr außerhalb der zyklischen Überwachung des Schwingverhaltens des Repeaters 10, d. h. zwischen dem zweiten und dritten Taktimpuls, die Entkopplungsdämpfung z. B. durch ein dicht vorbeifliegendes metallisches Luftfahrzeug derart drastisch ab, daß der Repeater 10 in Schwingung gerät. Der Schwingungsdetektor 90 erkennt den Schwingzustand des Repeaters 10 sowie die Tatsache, daß keine zyklische Abfrage des Repeaters 10 vorliegt, da er vom Taktgeber 85 keinen Taktimpuls empfangen hat. Der Schwingungsdetektor 90 signalisiert den Schwingungseinsatz des Repeaters 10 dem Taktgeber 85, der daraufhin einen Taktimpuls zum Pegelindikator 70 und zur Verstärkungs-Steuerungseinrichtung 80 überträgt. Da die Schwingung des Repeaters 10 außerhalb der zyklischen Überwachung aufgetreten ist, erzeugt die Verstärkungs-Steuereinrichtung 80 ein Steuersignal, das die Verstärkung des regelbaren Verstärkers 20 drastisch verringert, so daß der Repeater 10 zwar mit einer sehr schwachen Verstärkung betrieben wird, doch der Betriebszustand stabil ist. Der durch den Taktgeber 85 aktivierte Pegelindikator 70 stellt fest, daß der Signalpegel am Signalausgang 60 nunmehr unterhalb des optimierten, voreingestellten Signalpegels liegt. Zur Einleitung der zyklischen Überwachung des Schwingungsverhaltens des Repeaters 10 erzeugt der Taktgeber 85 wieder ein Taktsignal, das sowohl dem Schwingungsdetektor 90, dem Pegelindikator 70, dem Tastimpulsformer 110 und der Verstärkungs-Steuerungseinrichtung 80 zugeführt wird. Bei dem hier beschriebenen Beispiel ist zwar das Taktsignal zur Steuerung der periodischen Überwachung des Schwingungszustandes des Repeaters 10 unabhängig von dem Leistungsabfall am Signalausgang 60. Es ist jedoch denkbar, den Taktgeber 85 in Abhängigkeit von dem Signalpegel am Ausgang 60 des Repeaters 10 zu steuern. Der Taktgeber 85 erzeugt dann ein Taktsignal, das eine vorzeitige zyklische Überwachung des Repeaters 10 nach sich zieht. Wir kehren nunmehr zu dem beispielhaften Szenario zurück. Der Tastimpulsformer 110 erzeugt nachfolgend einen dritten Impuls 5, der bewirkt, daß die Verstärkung des stufenweise regelbaren Verstärkers 30 um 9 dB angehoben wird. Da mittlerweile die Entkopplungsdämpfung einen höheren Wert als die mittlere Entkopplungsdämpfung angenommen hat, weil z. B. das zuvor vorbeifliegende metallische Luftfahrzeug sich inzwischen weit vom Repeater 10 entfernt hat, tritt während der zyklischen Überwachung kein Schwingverhalten auf. Der Schwingungsdetektor 90 veranlaßt daraufhin die Verstärkungs-Steuerungseinrichtung 80, die Verstärkung des regelbaren Verstärkers 20 um einen kleinen Betrag von 0,5 dB anzuheben. Es ist aber auch denkbar, daß unter Ansprechen auf den Pegelindikator 70, der den deutlichen Leistungsabfall am Signalausgang 60 erkannt hat, die Verstärkung des regelbaren Verstärkers 20 um einen größeren Bertrag, beispielsweise um 1 dB angehoben wird. Dies ist in Fig. 2 und 4 dargestellt. Ferner kann der Pegelindikator 70 mit dem Taktgeber 85 verbunden sein, der dann die Periodendauer des Taktsignals in Abhängigkeit der Ausgangsleistung verändert. Beispielsweise wird die Periodendauer verkürzt, wenn der Pegelindikator 70 einen vorbestimmten Leistungsabfall am Signalausgang 60 detektiert. Auf diese Weise kann die Verstärkung des Repeaters 10 schneller an den voreingestellten optimalen Verstärkungswert herangeführt werden. Dank der Erfindung ist es daher möglich, den Repeater 10 nahezu während der gesamten Betriebszeit mit der maximal möglichen Verstärkung arbeiten zu lassen, wobei der vorgegebene Sicherheitabstand im wesentlich beibehalten wird.

Um während der zyklischen Überwachung bzw. Anhebung der Gesamtverstärkung um 9 dB das Ausgangssignal amplitudenmäßig zu begrenzen, können amplitudenbegrenzende Einrichtungen vorgesehen sein, die nicht dargestellt sind. Solche Begrenzerschaltungen sind allgemein bekannt. Der Fachmann kann aber beispielsweise auch Diodenbegrenzer mit vom Taktgeber 85 gesteuerter Vorspannung oder Begrenzerverstärker mit durch das Taktsignal des Taktgebers 85 umschaltbarer Begrenzerschwelle oder Anordnungen aus Verstärkerstufen mit fester Begrenzerschwelle und nachfolgenden schaltbaren Abschwächern - in Verbindung mit einer zu deren Abschwächung gegenläufigen Vergrößerung der Verstärkungsanhebung im stufenweise regelbaren Verstärker 30 - wählen.

Prinzipiell kann für den erfindungsgemäßen Repeater der gleiche Ablauf beschrieben werden, wenn in Fig. 4 die Kurve 1 nicht den Schwingungseinsatz sondern ein Maß für die Qualität der Signalübertragung des Verstärkers darstellt, das sich aus der Bitfehlerrate oder aus der Welligkeit der Übertragungsfunktion im Frequenzbereich ergibt. Die Tastimpulse 3, 4, 5,... lösen dann jeweils die Abfrage der zwischenzeitlich in der Überwachungs- und Auswerteeinrichtung_ermittelten Bitfehlerrate oder Welligkeit aus.

Die in Fig. 1 gezeigte Schaltungsanordnung eines adaptiven Repeaters kann zumindest teilweise oder auch ganz als kostengünstige integrierte Schaltung in einem gemeinsamen Funktionsblock zusammengefaßt sein.

## Patentansprüche

1. Vorrichtung zur geregelten Verstärkung von digitalen Signalen insbesondere für ein digitales Rundfunksystem umfassend
einen Signaleingang (15) und
einen Signalausgang (60),
wobei die Vorrichtung (10) eine voreingestellte Verstärkung (Vₒ) liefert,
**gekennzeichnet durch**
eine Einrichtung (100) zum impulsförmigen Erhöhen der voreingestellten Verstärkung um einen ersten vorbestimmten Betrag in vorbestimmten zeitlichen Abständen für jeweils eine vorbestimmte Zeitdauer und **durch**
eine Überwachungs- und Auswerteeinrichtung (90) zur Überwachung und Auswertung des Betriebszustandes der Vorrichtung (10) wenigstens in den vorbestimmten zeitlichen Abständen,
wobei in Abhängigkeit des Ausgangsignals der Überwachungs- und Auswerteeinrichtung (90) eine Vergrößerung oder eine Verkleinerung der voreingestellten Verstärkung um einen zweiten Betrag erfolgt.

2. Vorrichtung nach Anspruch 1,
**gekennzeichnet durch**
einen ersten regelbaren Verstärker (20) zur Lieferung der voreingestellten Verstärkung (Vₒ),
wobei die Einrichtung (100) zum zeitweisen Erhöhen der Verstärkung einen zweiten regelbaren Verstärker (30), einen Taktgeber (85) und einen mit dem zweiten regelbaren Verstärker (30) verbundenen Tastimpulsformer (110) aufweist.

3. Vorrichtung nach Anspruch 2,
**gekennzeichnet durch**
eine Einrichtung zur Verstärkungssteuerung (80), die eingangsseitig mit dem Taktgeber (85) und der Überwachungs- und Auswerteeinrichtung (90) sowie ausgangsseitig mit dem ersten Verstärker (20) verbunden ist, zur Verkleinerung oder Vergrößerung der voreingestellten Verstärkung um den zweiten vorbestimmten Betrag.

4. Vorrichtung nach Anspruch 2 oder 3,
**dadurch gekennzeichnet, daß** dem zweiten Verstärker (30) eine Endstufe (40) und ein Bandpaßfilter (50) nachgeschaltet sind.

5. Vorrichtung nach einem der Ansprüche 2 bis 4,
**gekennzeichnet durch** einen Pegelindikator (70), der eingangsseitig mit dem Signalausgang (60) und ausgangsseitig mit der Verstärkungs-Steuerungseinrichtung (80) verbunden ist, zur Erhöhung der voreingestellten Verstärkung um einen vorbestimmten Betrag.

6. Vorrichtung nach einem der Ansprüche 3 bis 5,
**dadurch gekennzeichnet, daß** die Verstärkungs-Steuerungseinrichtung (80) mit dem Taktimpulsformer (110) verbunden ist und unter Ansprechen auf diesen unterschiedliche Verstärkersteuerungssignale erzeugt.

7. Vorrichtung nach einem der Ansprüche 1 bis 6,
**dadurch gekennzeichnet, daß** die Überwachungs- und Auswerteeinrichtung (90) als Betriebszustand der Vorrichtung (10) deren Schwingungsverhalten überwacht und auswertet.

8. Vorrichtung nach einem der Ansprüche 4 bis 7,
**dadurch gekennzeichnet, daß** die Überwachungs- und Auswerteeinrichtung (90) als Betriebszustand der Vorrichtung (10) deren Änderung der Stromaufnahme überwacht und auswertet.

9. Vorrichtung nach einem der Ansprüche 4 bis 7,
**dadurch gekennzeichnet, daß** die Verstärkung der Vorrichtung (10) ampltitudenbegrenzt ist und die Überwachungs- und Auswerteeinrichtung (90) als Betriebszustand der Vorrichtung (10) die Oberwellen im Ausgangssignal der Endstufe (40) überwacht und auswertet.

10. Vorrichtung nach einem der Ansprüche 1 bis 7,
**dadurch gekennzeichnet, daß** die Überwachungs- und Auswerteeinrichtung (90) als Betriebszustand der Vorrichtung (10) die Bitfehlerrate des empfangenen digitalen Signal überwacht und mit einem vorbestimmten Wert vergleicht.

11. Vorrichtung nach einem der Ansprüche 4 bis 10, **dadurch gekennzeichnet, daß** die Überwachungs- und Auswerteeinrichtung (90) als Betriebszustand der Vorrichtung (10) die Welligkeit der Übertragungsfunktion im Frequenzbereich überwacht und auswertet.

12. Vorrichtung nach nach einem der Ansprüche 4 bis 10,
**dadurch gekennzeichnet, daß** die Überwachungs- und Auswerteeinrichtung (90) als Betriebszustand der Vorrichtung (10) die Reduzierung oder das Verschwinden von modulationsbedingten Pegelschwankungen im verstärkten Signal im Frequenzbereich überwacht und auswertet.

13. Vorrichtung nach einem der Ansprüche 1 bis 12,
**dadurch gekennzeichnet, daß** am Signaleingang (15) eine Empfangsantenne (17) und am Signalausgang (60) eine Sendeantenne (65) angeschaltet ist.

14. Verfahren zum adaptiven Regeln des Verstärkungsfaktors einer Verstärkervorrichtung nach einem der Ansprüche 1 bis 13
mit folgenden Verfahrensschritten:
a) Voreinstellen des Verstärkungsfaktors der Verstärkervorrichtung,
b) periodisches impulsförmiges Anheben des Verstärkungsfaktors jeweils für eine einstellbare Zeitdauer um einen ersten einstellbaren Betrag,
c) Überwachen und Auswerten des Betriebszustandes des Verstärkers wenigstens während des periodischen Anhebens des Verstärkungsfaktors nach Schritt c) und
d) Verkleinern oder Vergrößern des voreingestellten Verstärkungsfaktors um einen zweiten einstellbaren Betrag in Abhängigkeit des ausgewerteten Betriebszustands.

15. Verfahren nach Anspruch 14,
**dadurch gekennzeichnet, daß** in Schritt c) als Betriebszustand der Schwingungszustand des Verstärkers überwacht und ausgewertet wird und daß der Verstärkungsfaktor um den zweiten einstellbaren Betrag vergößert wird, wenn in Schritt c) keine Schwingung des Verstärkers festgestellt wird, und daß der Verstärkungsfaktor um den zweiten einstellbaren Betrag verkleinert wird, wenn in Schritt c) eine Schwingung des Verstärkers festgestellt wird.

16. Verfahren nach Anspruch 14 oder 15,
**dadurch gekennzeichnet, daß** der Betriebszustand des Verstärkers auch außerhalb der Zeitabschnitte des periodischen Anhebens des Verstärkungsfaktors überwacht und ausgewertet wird und daß in Abhängigkeit des Betriebszustandes der voreingestellte Verstärkungsfaktor um einen dritten einstellbaren Betrag verkleinert oder vergrößert wird, wobei der dritte einstellbare Betrag größer ist als der zweite einstellbare Betrag.

## Claims

1. Device for the regulated amplification of digital signals, particularly for a digital radio system, comprising
a signal input (15) and
a signal output (60),
the device (10) delivering a preset amplification (V₀),
**characterized by**
a means (100) for the pulsed increasing of the preset amplification by a first predetermined amount at predetermined time intervals for in each case a predetermined duration and by
a monitoring and evaluation means (90) for monitoring and evaluating the operating state of the device (10) at least at the predetermined time intervals, wherein, depending on the output signal from the monitoring and evaluation means (90), the preset amplification is increased or reduced by a second amount.

2. Device according to claim 1,
**characterized by**
a first regulatable amplifier (20) for delivering the preset amplification (V₀), the means (100) for temporarily increasing the amplification having a second regulatable amplifier (30), a clock generator (85) and a clock pulse shaper (110) connected to the second regulatable amplifier (30).

3. Device according to claim 2,
**characterized by**
a means for amplification control (80), said means (80) being connected on the input side to the clock generator (85) and the monitoring and evaluation means (90) as well as on the output side to the first amplifier (20), for reducing or increasing the preset amplification by the second predetermined amount.

4. Device according to claim 2 or 3,
**characterized in that** the second amplifier (30) is followed by an output stage (40) and a bandpass filter (50).

5. Device according to any one of claims 2 to 4,
**characterized by** a level indicator (70), said level indicator (70) being connected on the input side to the signal output (60) and on the output side to the amplification control means (80), for increasing the preset amplification by a predetermined amount.

6. Device according to any one of claims 3 to 5,
**characterized in that** the amplification control means (80) is connected to the clock pulse shaper (110) and, in responding to the latter, generates various amplifier control signals.

7. Device according to any one of claims 1 to 6,
**characterized in that** the monitoring and evaluation means (90) monitors and evaluates as the operating state of the device (10) the oscillatory characteristics thereof.

8. Device according to any one of claims 4 to 7,
**characterized in that** the monitoring and evaluation means (90) monitors and evaluates as the operating state of the device (10) the change in current consumption thereof.

9. Device according to any one of claims 4 to 7,
**characterized in that** the amplification of the device (10) is amplitude-limited and the monitoring and evaluation means (90) monitors and evaluates as the operating state of the device (10) the harmonics in the output signal from the output stage (40).

10. Device according to any one of claims 1 to 7,
**characterized in that** the monitoring and evaluation means (90) monitors as the operating state of the device (10) the bit error rate of the received digital signal and compares same with a predetermined value.

11. Device according to any one of claims 4 to 10,
**characterized in that** the monitoring and evaluation means (90) monitors and evaluates as the operating state of the device (10) the ripple of the transfer function in the frequency range.

12. Device according to any one of claims 4 to 10,
**characterized in that** the monitoring and evaluation means (90) monitors and evaluates as the operating state of the device (10) the reduction or disappearance of modulation-induced level fluctuations in the amplified signal in the frequency range.

13. Device according to any one of claims 1 to 12,
**characterized in that** a receiving antenna (17) is connected at the signal input (15) and a transmitting antenna (65) is connected at the signal output (60).

14. Method for the adaptive regulation of the amplification factor of an amplifier device according to any one of claims 1 to 13,
with the following method steps:
a) presetting of the amplification factor of the amplifier device;
b) periodic pulsed increasing of the amplification factor in each case for an adjustable duration by a first adjustable amount;
c) monitoring and evaluating of the operating state of the amplifier at least during the periodic increasing of the amplification factor according to step c) and
d) reducing or increasing of the preset amplification factor by a second adjustable amount as a function of the evaluated operating state.

15. Method according to claim 14,
**characterized in that**, in step c), the oscillatory state of the amplifier is monitored and evaluated as the operating state and the amplification factor is increased by the second adjustable amount if, in step c), no oscillation of the amplifier is detected, and **in that** the amplification factor is reduced by the second adjustable amount if, in step c), an oscillation of the amplifier is detected.

16. Method according to claim 14 or 15,
**characterized in that** the operating state of the amplifier is monitored and evaluated also outside the time portions of the periodic increasing of the amplification factor and **in that**, depending on the operating state, the preset amplification factor is reduced or increased by a third adjustable amount, the third adjustable amount being greater than the second adjustable amount.

## Revendications

1. Dispositif pour l'amplification régulée de signaux numériques, en particulier pour un système de radiodiffusion numérique incluant
une entrée de signal (15) et
une sortie de signal (60),
ce dispositif (10) fournissant une amplification (V₀) préréglée
**caractérisé par**
une installation (100) conçue pour l'augmentation par impulsions de l'amplification préréglée d'une première quantité prédéfinie dans des intervalles de temps prédéfinis pour une période prédéfinie, et par
une installation de surveillance et d'analyse (90) conçue pour la surveillance et l'analyse des conditions de fonctionnement du dispositif (10) au moins dans les intervalles de temps prédéfinis,
avec une augmentation ou une diminution de l'amplification préréglée d'une deuxième quantité en fonction du signal de sortie de l'installation de surveillance et d'analyse (90).

2. Dispositif selon la revendication 1,
**caractérisé par**
un premier amplificateur (20) réglable pour la fourniture de l'amplification (V₀) préréglée, l'installation (100) comportant, pour l'augmentation périodique de l'amplification, un deuxième amplificateur réglable (30), une horloge (85) et un conformateur d'impulsions (110) relié au deuxième amplificateur (30) réglable.

3. Dispositif selon la revendication 2,
**caractérisé par**
une installation pour le contrôle de l'amplification (80) qui est reliée, au niveau de l'entrée, à l'horloge (85) et à l'installation de surveillance et d'analyse (90) et, au niveau de la sortie, au premier amplificateur (20), pour la diminution ou l'augmentation de l'amplification préréglée d'une deuxième quantité prédéfinie.

4. Dispositif selon la revendication 2 ou 3,
**caractérisé en ce qu'**un étage de sortie (40) et un filtre de bande (50) sont placés derrière le deuxième amplificateur (30).

5. Dispositif selon l'une quelconque des revendications 2 à 4,
**caractérisé par** un indicateur de niveau (70) qui est relié à la sortie de signal (60) au niveau de l'entrée et à l'installation de contrôle de l'amplification (80) au niveau de la sortie, pour l'augmentation de l'amplification préréglée d'une quantité prédéfinie.

6. Dispositif selon l'une quelconque des revendications 3 à 5,
**caractérisé en ce que** l'installation de contrôle de l'amplification (80) est reliée au conformateur d'impulsions (110) et, en réponse à celui-ci, produit différents signaux de contrôle de l'amplification.

7. Dispositif selon l'une quelconque des revendications 1 à 6,
**caractérisé en ce que** l'installation de surveillance et d'analyse (90) surveille et analyse la réaction du dispositif (10) aux vibrations pour déterminer les conditions de fonctionnement du dispositif (10).

8. Dispositif selon l'une quelconque des revendications 4 à 7,
**caractérisé en ce que** l'installation de surveillance et d'analyse (90) surveille et analyse toute modification du courant absorbé pour déterminer les conditions de fonctionnement du dispositif (10).

9. Dispositif selon l'une quelconque des revendications 4 à 7,
**caractérisé en ce que** l'amplification du dispositif (10) est limitée au niveau de l'amplitude et **en ce que** l'installation de surveillance et d'analyse (90) surveille et analyse les harmoniques dans le signal de sortie de l'étage de sortie (40) pour déterminer les conditions de fonctionnement du dispositif (10).

10. Dispositif selon l'une quelconque des revendications 1 à 7,
**caractérisé en ce que** l'installation de surveillance et d'analyse (90) surveille le taux d'erreur sur les bits du signal numérique reçu et le compare à une valeur prédéfinie pour déterminer les conditions de fonctionnement du dispositif (10).

11. Dispositif selon l'une quelconque des revendications 4 à 10,
**caractérisé en ce que** l'installation de surveillance et d'analyse (90) surveille et analyse l'ondulation de la fonction de transmission dans la gamme de fréquences pour déterminer les conditions de fonctionnement du dispositif (10).

12. Dispositif selon l'une quelconque des revendications 4 à 10,
**caractérisé en ce que** l'installation de surveillance et d'analyse (90) surveille et analyse la réduction ou la disparition de variations de niveau conditionnées par la modulation dans le signal amplifié dans la gamme de fréquences pour déterminer les conditions de fonctionnement du dispositif (10).

13. Dispositif selon l'une quelconque des revendications 1 à 12,
**caractérisé en ce que** une antenne de réception (17) est placée à l'entrée du signal (15) et une antenne de transmission (65) est placée à la sortie du signal (60).

14. Dispositif pour le réglage adaptatif du facteur d'amplification d'un amplificateur selon l'une quelconque des revendications 1 à 13 avec les étapes suivantes :
a) préréglage du facteur d'amplification de l'amplificateur
b) augmentation périodique par impulsions du facteur d'amplification pour une période réglable, d'une première quantité réglable
c) surveillance et analyse des conditions de fonctionnement de l'amplificateur au moins pendant l'augmentation périodique du facteur d'amplification après l'étape c) et
d) diminution ou augmentation du facteur d'amplification préréglé d'une deuxième quantité réglable en fonction des conditions de fonctionnement analysées.

15. Dispositif selon la revendication 14,
**caractérisé en ce que**, au cours de l'étape c), la réaction de l'amplificateur aux vibrations est surveillée et analysée pour déterminer les conditions de fonctionnement et que le facteur d'amplification est augmenté de la deuxième quantité réglable, quand, au cours de l'étape c), aucune vibration de l'amplificateur n'est constatée, et que le facteur d'amplification est diminué de la deuxième quantité réglable quand, au cours de l'étape c), une vibration de l'amplificateur est constatée.

16. Dispositif selon la revendication 14 ou 15,
**caractérisé en ce que** les conditions de fonctionnement de l'amplificateur sont également surveillées et analysées en dehors de la phase de l'augmentation périodique du facteur d'amplification et **en ce que**, en fonction des conditions de fonctionnement, le facteur d'amplification préréglé est diminué ou augmenté d'une troisième quantité réglable, cette troisième quantité réglable étant supérieure à la deuxième quantité réglable.
